Europäisches Patentamt

European Patent Office

Office européen des brevets

⑩

(11) Publication number: **0 084 465**
**B1**

(12) **EUROPEAN PATENT SPECIFICATION**

(45) Date of publication of patent specification: **21.03.90**

(21) Application number: **83400012.7**

(22) Date of filing: **04.01.83**

(51) Int. Cl.⁵: **H 01 L 21/76,** H 01 L 27/06,
H 01 L 27/08, H 01 L 29/06,
G 11 C 17/00

(54) Oxide isolation process for standard RAM/PROM and lateral PNP cell RAM.

(30) Priority: **04.01.82 US 336802**

(43) Date of publication of application:
**27.07.83 Bulletin 83/30**

(45) Publication of the grant of the patent:
**21.03.90 Bulletin 90/12**

(84) Designated Contracting States:
**DE FR GB IT NL**

(56) References cited:
**EP-A-0 001 300**
**EP-A-0 004 298**
**EP-A-0 028 306**
**FR-A-2 334 198**
**FR-A-2 369 652**
**US-A-3 648 125**
**US-A-3 904 450**
**US-A-4 122 542**

(73) Proprietor: **FAIRCHILD SEMICONDUCTOR
CORPORATION**
**10400 Ridgeview Court P.O. Box 1500**
**Cupertino, California 95014 (US)**

(72) Inventor: **Shideler, Jay Albert**
**11 Murphy Place**
**San Mateo California 94402 (US)**
Inventor: **Mishra, Umeshwar Dutt**
**1623 Crow Court**
**Sunnyvale California 94087 (US)**

(74) Representative: **Sparing Röhl Henseler
Patentanwälte European Patent Attorneys**
**Rethelstrasse 123**
**D-4000 Düsseldorf 1 (DE)**

EP 0 084 465 B1

Courier Press, Leamington Spa, England.

# Description

This invention relates to bipolar programmable read-only memories (often called "PROMs") and in particular to a structure wherein an epitaxial layer of one conductivity type is used with a substrate of opposite conductivity type together with oxide isolation thereby allowing Schottky diodes and transistors to be used in junction-programmable PROMs to be made in an oxide isolated structure and to a method for making these structures.

Various ways have been proposed to isolate electrically a plurality of pockets of semiconductor material in each of which one or more circuit elements can be formed. A number of these techniques are summarized in the introduction to US—A—3,648,125. Two goals of these various isolation methods have been to reduce the size of the isolation regions as a proportion of the total area of silicon available for the formation of active devices and to decrease the size of the active devices. A major improvement in packing density over the previous packing densities was achieved by this method and structure wherein a thin silicon epitaxial layer was subdivided into electrically isolated pockets by a grid of oxidized regions of the epitaxial silicon material extending through the epitaxial material to an underlying laterally-extending isolation PN junction. It was recognized that the use of diffused regions for isolation and for the formation of active semiconductor devices resulted in larger, less well-defined circuits than desired for many applications. Therefore, the diffused isolation regions were replaced with field oxide.

Among the different types of semiconductor devices which have been fabricated using the Peltzer oxide isolation technique are bipolar memories and programmable read-only memories. Programmable read-only memories are well-known in the semiconductor arts. One of the first documents disclosing a programmable semiconductor memory was US—A—3,191,151 disclosing a programmable diode array. The array comprised a plurality of pairs of two diodes connected back-to-back. The array was programmed by sending a current pulse of the proper magnitude and direction through selected ones of the back-to-back diodes thereby destroying the junction of each of these back-biased diodes without affecting the connected forward-biased diode. The pulse converted the junction of each selected back-biased diode to a short circuit. There was also disclosed the use of a fuse which when destroyed converted the circuit from conducting to non-conducting. Additional documents disclosing programmable read-only memories include US—A—3,733,690; 3,742,592; and 3,848,238. These documents disclose a programmable read-only memory also using avalanche break-down to program selected devices and a method for achieving avalanche breakdown as in US—A—3,191,151.

However, heretofore, it has not been feasible to combine the avalanche breakdown of a PN junction with the recessed oxide isolation structure of the prior art to yield a programmable read only memory programmable by avalanche breakdown of a PN junction because the voltages required to breakdown such a junction were close to the breakdown voltages of oxide isolated structures.

EP—A—0 001 300 discloses a method of manufacture of a vertical bipolar transistor adjacent to a sunken oxide in a semiconductor epitaxial layer. FR—A—2,369,652 discloses fabrication of programmable read-only memories using vertical transistor action in a semiconductor epitaxial layer.

The present invention as defined in Claim 1 turns to advantage certain of the features of the prior art oxide isolation process to provide a structure which is particularly useful in the manufacture of programmable read-only memories .(PROMs). In accordance with this invention, the breakdown voltages associated with prior art recessed oxide isolation structures and particularly the sidewall regions of the isolated semiconductor islands adjacent the recessed oxide are substantially increased by using an N type epitaxial layer on a P type substrate and turning to advantage the pile up of N type impurities adjacent the recessed oxide during thermal oxidation of the epitaxial layer and by preventing P type impurities used to form channel stops in the field of the device from reaching the sidewalls of the silicon islands. In addition, the collector-emitter breakdown voltage ($LV_{CEO}$) of NPN vertical transistors formed in the semiconductor islands when this process is used to make PROMs is increased by implanting a P type impurity in those portions of the silicon islands to be occupied by the P type base regions of the NPN vertical transistors. Each base region and each emitter-base junction has its lateral dimensions defined completely by the oxidized portions of the epitaxial layer.

In one embodiment of this invention, a PROM is made from a plurality of transistors each having an emitter, a floating base and a collector, wherein the emitter-base junction of each of selected transistors is destroyed by a programming current, thereby eliminating the need for prior art fuses (such as nichrome fuses) and the extra processing and yield difficulties associated with the nichrome process.

A method for manufacturing a PROM in accordance with the present invention is defined in patent Claim 9; patent Claims 10 through 13 define further preferred features of the method set forth in Claim 9.

This invention departs from the prior art in several respects. First, it porvides a ten (10) mask process for use in manufacturing oxide isolated PROMs as opposed to the prior art, processes requiring more masks than ten (10) and typically thirteen (13) masks. This invention allows the manufacture of PROMs using a single process. By eliminating the field predeposition in the sidewall, the sink can be made smaller whether or not it is hard or soft. Finally, a Schottky TTL can be used with significant improvements in speed.

This invention will be more fully understood in conjunction with the following detailed description taken together with the following drawings (which, for illustrative purposes, are not drawn to scale).

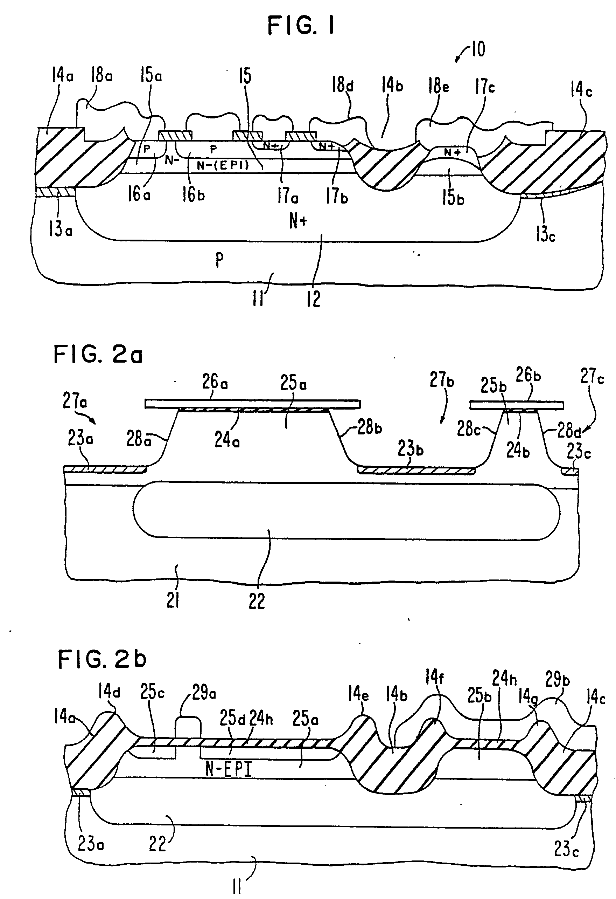

Figure 1 illustrates a portion of a cross-section of a device structure which is a non-claimed preform of the present invention.

Fgure 2a illustrates in cross-section a portion of the device structure of Figure 1 during an intermediate stage of its manufacture;

Figures 2b and 2c illustrate the structure shown in cross-section in Figure 2d during intermediate stages of its manufacture;

Figure 2d illustrates in cross-section a portion of the structure of another embodiment which is not claimed,

Figure 3 illustrates graphically the impurity distribution across the emitter, base and collector of the structure shown, for example, in cross-section in Figure 2d.

Figure 4a illustrates in cross-section a PROM cell constructed in accordance with this invention.

Figure 4b shows in top view a PROM cell similar to that shown in cross-section in Figure 4a.

Figure 4c shows in top view another embodiment of a PROM cell of Figure 4a.

Figure 4d is an isometric cutaway view of a portion of the structure shown in Figure 4c.

Figures 4e and 4f illustrate the reduction in device size achievable using the structure of this invention.

Figures 4g and 4h are circuit schematics of the structure of Figures 4e and 4f, respectively, before and after programming.

Figures 5a through 5g illustrate the technique used to program the PROM cells of this invention.

Detailed description

The following description is intended to be illustrative only and is not intended to limit the scope of the invention. While one set of conductivity types is shown, it should be understood that for many applications these conductivity types can be reversed.

The starting material for the process comprises a P type silicon substrate of either <100> or <111> crystallographic structure (<100> is preferred but <111> has been successfully used) having a resistivity of between 1.5 and 3.0 ohms-cm or higher. Using a lower resistivity substrate of about 0.2 to 0.4 ohms-cm or less tends to degrade or ruin the vertical isolation in the to-be-formed epitaxial layers by outdiffusion of P type dopant from the substrate. With this in mind, other substrate resistivities can be used, as appropriate. The substrate 11 (Figure 1) is precleaned and inspected and then oxidized at about 1000°C using a standard thermal oxidation process to form an oxide layer on at least one surface of the substrate to a thickness of about 800 nm (8,000Å). The bare backside of the wafer is then back sanded in a well-known manner to assist in gettering certain metallic impurities during subsequent processing. The wafer is again cleaned in a well-known manner and inspected and then a first mask is used to define the openings in the oxide through which an impurity will be diffused to form the buried layers (such as buried layer 12 in Figure 1) of the device. An opening is then etched through the oxide using a standard HF etch and buried layer 12 is formed by diffusing at 1245°C antimony dopant through the opening in the oxide. Buried layer 12 is of N+ conductivity type when the substrate 11 is of P type conductivity, as shown, and has a surface resistance (V/I) of about 5.0 to 9.0 ohms.

Following formation of buried layer 12, the oxide is removed from the surface of substrate 11, the wafer is cleaned and inspected and an N type epitaxial layer 15 is formed on its surface using standard epitaxial growth techniques involving the decomposition of silane, silicon tetrachloride, or dichlorosilane. Dichlorosilane is preferred. The epitaxial layer is formed to a thickness of about 1.5 micrometer and has a resistivity of 0.4 to 0.6 ohm-cm.

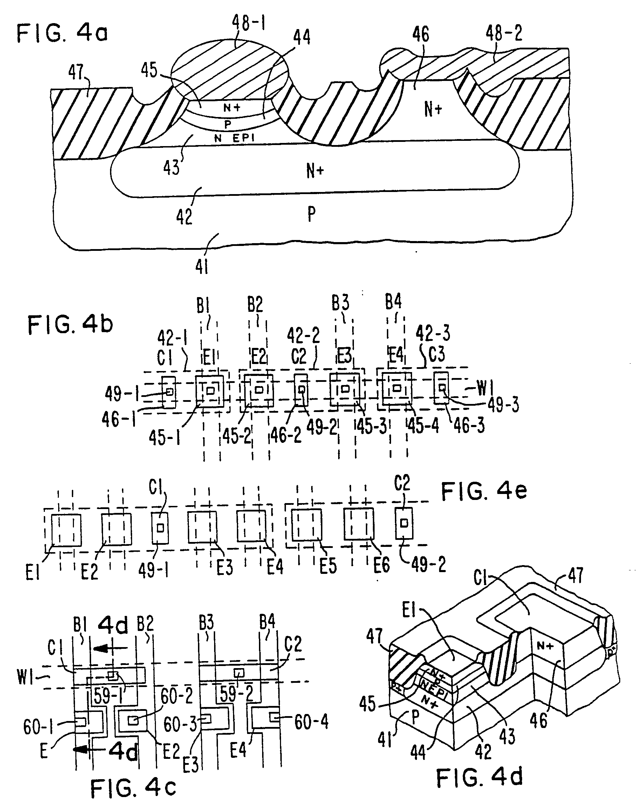

Following the formation of epitaxial layer 15, the wafer is again cleaned and inspected. Two different types of oxide-nitride layers can be formed on epitaxial layer 15 (shown as layer 25 in Figures 2a to 2d and as layer 43 in Figure 4a). The first comprises a thin silicon oxide layer [20 nm (200Å)] thermally-grown on the epitaxial layer 15 followed by the deposition of a thin silicon nitride layer [110 nm (1100Å)]. This thin "epi-ox-thin-nitride" sandwich is used to form channel stops with very low energy implants of 15 KEV boron in the to-be-formed grooves. The second comprises a thick sandwich including a thick thermal oxide layer 24 [40 nm (400Å)] formed on the epitaxial layer together with a thick silicon nitride layer 26 [150 nm (1500Å)]. This second layer is used when the channel stop is to be implemented using 20 KEV boron. The advantage of using the thicker oxide-nitride layer (and this thicker layer is preferred) is that it is much more economical to implant the channel stops with a 20 KEV implant than it is with a 15 KEV implant because beam currents fall off dramatically when operating in ion implanter at lower energies. The 40 nm (400Å) oxide layer is formed at 1000°C by using five minutes of $N_2$, thirty minutes of dry $O_2$ and five minutes of $N_2$. A nitride layer of about 150 nm (1500Å) thickness is then formed using low pressure chemical vapor deposition involving the decomposition of dichlorosilane ($SiH_2Cl_2$) and ammonia ($NH_3$). As an alternative, either thick or thin oxide layers can be interchanged with thick or thin nitride layers.

The nitride layer 26 is then immediately oxidized (60 minutes in 1000°C steam) to form a thin silicon dioxide layer (not shown for simplicity) of about 5 nm (50Å) on top of the nitride to serve as a mask to define the isolation grooves to be formed in the underlying epitaxial layer. Photoresist is used to define the oxide on the nitride and this exposed oxide is then removed by placing the wafer in a hydrofluoric etch of well-known constituents for about sixty (60) seconds to expose the underlying nitride. The nitride 26 exposed by removing the thin 5 nm (50Å) oxide layer is then etched using a well-known phosphoric acid etch at 160°C for sixty (60) minutes to expose portions of the underlying oxide layer 24.

As an alternative to the use of phosphoric acid to etch the nitride 26, the formation of a 5 nm (50Å) layer of oxide on top of the nitride 26 can be omitted and in lieu thereof the photoresist mask can be used as a direct mask for plasma etching of the nitride. This saves one step in the process and allows dry processing to be used.

The exposed oxide 24 beneath the previously removed nitride 26 is then etched and removed using a well-known buffered HF etchant for about 60 seconds followed by a rinse in deionized water and an acetic acid dip and a 10 to 1 HF dip. Silicon 25 is then etched in a well-known manner to form grooves in the silicon of about 600—800 nm (6,000—8,000Å) thick, (preferably about $750\pm50$ nm ($7,500\mp500$Å). The etching of the silicon 25 removes silicon underlying the silicon nitride mask 26a, 26b as shown in Figure 2a (note that the ends of this mask protrude over the edges 28a, 28b, 28c and 28d of grooves 27a, 27b formed in the epitaxial silicon 25 and thus protect the underlying edges 28a, 28b, 28c and 28d of silicon islands 25a and 25b from the impurity to be implanted into the bottoms of grooves 27a, 27b, 27c to form channel stops 23a, 23b and 23c). This allows vertical isolation between the well-known channel stops 23a, 23b and 23c and the active devices formed in islands 25a and 25b. A typical implant dose for the boron ions used to form the channel stop regions 23a, 23b, 23c is $1.5\times10^{14}$ ions/cm$^2$ at 20 KEV.

In lieu of using boron for the ion implant channel stop, BF$_2^+$ may also be used which allows the use of the thin oxide [20 nm (200Å)] and thin silicon nitride [110 nm (1100Å)] layers. Whun using BF$_2^+$, a 35 KEV implant may be typically used which allows a more efficient use of the implanter.

Following implantation of the channel stops, as an option the wafer can be annealed at 1000°C for thirty (30) minutes in N$_2$ to yield a V/I of 100 to 140 ohms in the groove bottoms. This step is not always necessary and is often done just on test wafers for comparison purposes.

The boron impurity formed into channel stop regions 23a, 23b, 23c is then driven into the substrate in a nitrogen-annealing step for 3 hours at a temperature of 1,000°C followed by a 12-hour wet thermal oxidation cycle at 1000°C and five minutes dry 0$_2$ at 1000°C to grow oxide in grooves 27a, 27b and 27c. A controlled push and pull of the wafers into the tube is used. Typically this oxide is grown to a thickness of approximately 1750 nm (17,500Å). However, by using a thinner epitaxial layer and by utilizing vertical isolation, a thinner oxide (typically about 1100 nm (11,000Å) in the grooves may be grown. A thinner oxide gives the added advantages of reducing processing times, reducing out diffusion of the buried layer into the epitaxial layer, improving metal coverage over field oxide, and reducing stress set up where the grown oxide butts up against the silicon islands. This stress occurs during the growth of the isolation oxide as it expands upward and outward against the silicon islands. The resulting structure including field oxide 14a, 14b, and 14c appears in cross-section in Figure 2b. This field oxide is formed through thermal oxidation and the result is that a major portion of the boron impurity contained in P type regions 23a, 23b and 23c is consumed by the oxide 14 in accordance with the well-known redistribution effect due to the different segregation coefficients of boron in the underlying silicon 11 and the oxide 14. See, for an explanation of this phenomenon, A. S. Grove's book entitled "Physics and Technology of Semiconductor Devices" published by John Wiley and Sons, Inc. 1967, page 69, et al, and the papers on this phenomenon cited there on page 85. Because boron depletes from a region adjacent to thermally-grown oxide during the oxidation process (i.e., boron has a "negative segregation coefficient"), these channel stop regions must be overcompensated with boron so that when the thermal oxide is grown in the grooves, enough residual boron is left underneath the oxide to form an effective channel stop. Note that P type region 23b (Fgure 2a) is rendered to N type by the higher dopant concentration out-diffusing N+ buried layer 22 as are some portions of regions 23a and 23c (see Figure 2b).

A word is in order here about the purpose of the annealing step prior to the growth of the thermal oxide in the isolation grooves. During isolation field oxidation, certain portions of the boron field implant dopant are lost in the oxide due to the redistribution of impurity as discussed above. To reduce the amount of field implant dopant lost during isolation field oxidation, the wafer is annealed as described above for up to three to four hours prior to field oxidation. This anneal step not only repairs the silicon lattice damage caused by the channel stop ion implant, thus preventing irreparable defects from occurring in this region during the growth of field oxidation, but also drives the implant deep enough into the silicon to prevent it from being consumed too much during the field oxidation. However, excessively long anneals can cause the boron field implant to diffuse too far laterally into the silicon islands which ruins vertical isolation and can short lateral PNP emitters to collectors.

At this point in the process, when used to make PROMS a sink mask is sometimes formed on the wafer to define windows or openings to the sink regions 25b of the devices. Following the formation of the sink mask, the wafer is placed in a buffered HF etch for about sixty (60) seconds to remove thermally grown oxide on the nitride layer 26b, nitride layer 26b is then removed by a 160°C phosphoric acid etch for sixty (60) minutes followed by a well-known 10 to 1 HF dip (eight minutes) to remove oxide layer 24b (Figure 2a) and clean the wafer. A PBr$_3$ predeposition is applied to the wafer by first placing the wafer in a nitrogen atmosphere with two percent (2%) oxygen for ten (10) minutes followed by ten minutes of PBr$_3$ from a 33°C source, followed by 15 seconds of nitrogen with two percent oxygen at 900°C. One minute is taken for insertion of the wafer into the furnace and one minute for removal. The V/I for the sink region should be about 3.5 to 5.5 ohms.

There follows a 10 to 1 HF dip for ten seconds followed by a rinse and dry of the wafer. Then the wafer is oxidized for fifteen (15) minutes in dry oxygen, followed by ten (10) minutes in steam and five (5) minutes in dry oxygen. Twelve minutes are taken to push the wafer into the furnace and the same time is taken to remove the wafer from the furnace. The furnace is ramped from 880°C to 1000°C during this oxidation and the desired oxide thickness of 150 nm (1500Å). The V/I of the sink region should be 3.5 to 5.5 ohms.

Next, the nitride layer 26a (Figure 2a) is stripped from the device by first using a buffered HF etch for fifteen (15) seconds to remove the oxide on the nitride layer and then using a 160°C phosphoric acid etch for sixty (60) minutes to remove nitride layer 26a. The epitaxial thermal oxide 24a [40 nm (400Å thick)] is left on the device. The base region beneath the remaining epitaxial oxide 24a is thermally oxidized at 1000°C in ten (10) minutes dry O$_2$ and twenty (20) minutes steam to a thickness of about 220 nm (2,200Å) using standard processing to yield the oxide 24h overlying the sink region 25b and the active device region 25a on the structure shown in Figure 2b.

It is often desired to include an additional 1,000°C 30-minute dry oxygen or N$_2$ cycle at the end of the base wet oxidation cycle. This step aids in reducing the negative segregation coefficient of boron depletion from silicon. The optimum time for the oxygen or nitrogen cycle (and nitrogen is preferred) is selected so that the boron impurity is not driven so deeply into the epitaxial layer or substrate as to lose vertical isolation but long enough to maximize the boron concentration next to the oxide layer. This high temperature nitrogen cycle results in improved collector to collector electrical isolation.

The third mask, called the base exclusion mask or "base mask", is now applied to the device. This base exclusion mask (typically a photoresist layer 29) is applied to exclude from certain areas (the N type base of a to-be-formed lateral PNP transistor, the N type collector sink, and any high value resistors to be formed in the structure) the p-type impurity to be implanted in the N-type epitaxial layer 25 to form certain PNP emitter and collector regions to be described shortly. The implant also forms the active and inactive base regions of the NPN transistor. Typically, this mask is used to configure photoresist layer 29 so as to retain portions of the photoresist over the N type base region of the to-be-formed PNP lateral transistor, the collector sink and the high value resistors, thereby preventing P type ions from being implanted into these regions. In addition, a Schottky region can be formed by the base exclusion mask.

Following the patterning of this photoresist 29a, 29b (Figure 2b) to form the base exclusion mask, a P type impurity such as boron is implanted into the top surface of the device through the thin oxide layer 24h over the top surface of the device. Oxide 24h not only serves as a subsequent masking media but also assists in preventing unwanted damage to the silicon in which the impurity is being implanted. However, the implant dose is sufficiently low to prevent serious damage to this silicon even without oxide 24h. Photoresist 29a and 29b and thick field oxide 14a, 14b and 14c prevent boron from reaching the underlying portions of the semiconductor material. However, boron ions penetrate oxide 24h to reach the top surface of islands 25a and 25b and form P type emitter and collector regions 25c and 25d, respectively, of the to-be-formed lateral PNP transistor, form portions of the P type base region 25d of any to-be-formed vertical NPN transistor, and P type base resistors. Typical doses for formation of boron regions 25c and 25d are $7 \times 10^{+13}$ ions/cm$^2$ with an implantation energy of 117 KEV.

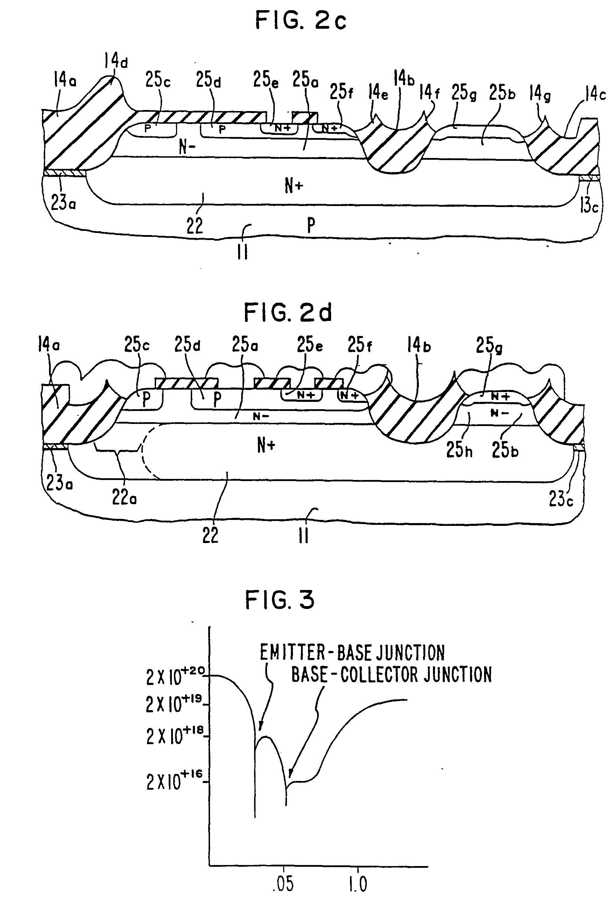

Next, photoresist 29a and 29b is stripped from the device. This is followed by the formation of an NPN emitter mask (the fourth mask to be used in wafer fabrication or, if the sink option described above was employed, the fifth mask). This mask defines the emitters 25e and 25f (Figure 2c) formed in P region 25d of the NPN vertical transistor and the buried layer contact region 25g to the buried layer 22 and collector 25a of the NPN vertical transistor.

Next, the isolation oxide formed in region 14b is etched back using a buffered HF etch for four (4) minutes to remove parts of portions 14e and 14f thereof (see and compare Figures 2b and 2c which illustrate this step schematically). When etching back the isolation oxide formed in region 14b as described above, which is done simultaneously while etching the NPN emitter openings in oxide 25h at emitter mask, an over-etch of approximately 2,000Å is done so that approximately 400 nm (4,000Å) of oxide is removed over a portion of the field oxide regions adjacent the to-be-formed emitter regions. This creates a 400 nm (4,000Å) step. This step is small enough to cause no problem of step coverage by the metal to be used to contact certain active regions of the device. However, in carrying out this etch, there is a risk that the etch will remove the field oxide portions 14e and 14f too far down the silicon islands 25a, 25b sidewall, thereby exposing portions of these sidewalls to the N type emitter diffusion which causes the N type emitter region 25f to be formed closer to the N+ buried layer 22 than desired. I$_{CEO}$ implant of boron ($7.0 \times 10^{+12}$/ cm$^2$ at 150 KEV) is designed to provide a selected boron impurity concentration in the active P region 25d just beneath and along the oxide sidewalls of silicon islands 25a and 25b next to emitter 25f and sink 25g to prevent $I_{CEO}$ leakage (that is, leakage between the collector and the emitter of the device with the base open) of all NPN transistors in the circuit (including the peripheral circuits of the RAM or PROM arrays). In addition, the $I_{CEO}$ implant serves as a portion of the active base 25d of the NPN vertical transistor. If the option of "soft" sinks is used, to keep the $I_{CEO}$ implant out of the sink regions (25g, 25h) an extra mask must be inserted at this point to cover up the sinks. This mask comprises a photoresist. This mask would normally be used at sink or at the third masking step if a hard sink (i.e., a sink containing additional N type impurity) were used. In essence, in going from a hard sink to a soft sink, the masking step normally down as the third step is now inserted between the fifth and sixth masking steps.

In addition, an $LV_{CEO}$ implant of boron ($1 \times 10^{14}$/ $cm^2$ at 70 KEV) is used at this point in the process if PROMS are being made, to increase $LV_{CEO}$ of the vertical NPN transistors in the array (to be discussed later in conjunction with Figure 4a). This implant lowers the beta and thus raises $LV_{CEO}$ of the vertical transistors in the memory array thereby increasing the programming yield of this array. This implant is not made in the peripheral devices which, therefore, must be masked.

Next, photoresist is stripped and the wafer is annealed at 1000°C for thirty (30) minutes in nitrogen with two (2) percent oxygen. Next the wafer is cleaned (fifteen seconds in 10 to 1 HF) and an emitter predeposition using phosphorous (preferably $PBr_3$ at 960°C for six (6) minutes) provides N+ regions 25e and 25f for the emitters of the NPN vertical transistor. Simultaneously, an N+ sink diffused region 25g is formed over the top of island 25b (see Figure 2C). This is followed by a 100 to 1 HF dip for fifteen seconds to clean the wafer and the wafer is then rinsed and dried.

The fifth mask comprises the contact mask for the PNP emitter and collector and the NPN base, Schottky contact and base resistors. The base 25d of the vertical NPN transistor containing multiple emitters 25e and 25f also serves as the collector of the lateral PNP transistor and thus the PNP collector and the NPN base contact comprise the same contact structure as is apparent from Figure 2d. The PNP base contact is made through the collector sink 25g, 25h in silicon island 25b, buried layer 22 to the N type region 25a which serves as the collector of the NPN vertical transistor and as the base pickup of the PNP lateral transistor. The "soft" sink means that the N+ impurity in region 25g extends into only a portion of region 25b, leaving the N epitaxial material of region 25h substantially unaltered. This soft sink provides about 100—200 ohms vertical resistance in the circuit. A "hard" sink comprises N+ impurity extending through region 25h to buried collector contact 22. Contact is made to regions 25c and 25d by forming photoresist on the surface of the structure to leave exposed the regions of oxide 24h to be removed to expose the contact areas on these regions. Oxide 24h is removed by submerging the wafer in a buffered HF etch for four (4) minutes.

The remainder of the processing is standard, requiring formation of the contact openings to the various regions of the device and the formation of the contacts, interconnecting lead structures and dielectric isolation. Thus, these steps will not be described in detail.

The features of the above-described process include the fact that the PNP emitter and collector regions 25c and 25d and the NPN collector and PNP base contact are self-aligning in the sense that at least three of the four sides of these regions are defined by the field oxides 14a, 14b and 14c (Figures 2a through 2d). Although Figures 2a through 2d illustrate the structure of this invention in cross-section, it should be realized that the top view of this structure would show the field oxide defining the lateral dimensions of islands 25a and 25b. The lateral dimension of the PNP base (the remainder of the N epitaxial layer 25a shown in Figure 2b to 2d) parallel to the plane of the drawings of Figures 2a through 2d is approximately 2.5 microns. The lateral dimension of the PNP base perpendicular to the plane of the drawings of Figures 2a through 2d is reduced by the lateral growth of the oxide 14 during the formation of field oxide. This base dimension is defined by the base exclusion mask (the third mask).

The sink formed in region 25b can be "soft"; that is, no sink diffusion or ion implantation takes place in the sink region.

Care must be exercised along the sidewall of the oxide isolation 14a, 14b and 14c due to phosphorous pile-up. A somewhat heavier ICEO implant may be needed to prevent sidewall channels from forming betwseen the buried layer 22 and the N type emitter 25f (Figure 2C) for example. However, higher implanted doses will suppress the beta of the NPN vertical transistor comprising regions 22, 25a, 25e and 25f.

The rather low PNP emitter and collector dopant concentrations (about $2 \times 10^{+18}$/$cm^3$) cause a low PNP beta due to poor emitter efficiency. Typical betas for this structure have been found to be 0.2 to 0.8. For a completely oxide walled structure, betas of 1 to 2 have been noted. The PNP transistor serves only as a load and thus these low betas are acceptable. As an important added advantage, the poor PNP emitter efficiency substantially reduces minority carrier injection into the substrate, thus improving circuitry efficiency. Since the PNP emitter (formed by the single base boron implant) is of relatively low concentration, the emitter injection efficiency of the PNP into the substrate is very low, compared to a PNP emitter formed by a high dopant concentration plug. This substantially reduces electron injection into the substrate thus alleviating the RAM or PROM $\phi$ stack floating problem ($\phi$ is the voltage drop across a forward biased PN junction). The φ stack floating problem refers to the increase in the reference voltage levels measured at each PN junction of a number of diodes connected in series as a result of ground loop currents increasing the voltage of the ground as seen by each junction (i.e., the φ stack problem changes the voltage of ground).

The above-described process produces a structure compatible with the "vertical fuse" programming profile used to form PROMs by avalanching and therefore destroying selected emitter-base junctions.

In one embodiment, arsenic is used as the implant dopant to form the emitters 25e and 25f (a dosage of $1 \times 10^{16}$ ions/cm$^2$ at 60 KEV is preferred). This implant is preferably made through a 25 nm (250Å) thick thermal oxide layer which is regrown after forming the emitter windows. Both the base and emitter implants are driven in together. The base implant must of much higher dosage (typically around $5 \times 10^{14}$ to $10^{15}$ ions/cm$^2$). The arsenic dopant is just slightly shallower so as to leave only the steep leading edge of the base implant in front of the emitter. The relative concentrations as a function of depth of the emitter-base and base-collector junctions in the device are shown in Figure 3. The peak concentration of the emitter is $2 \times 10^{20}$/cm$^3$ while the peak concentration of the base is about $2 \times 10^{18}$/cm$^3$. The result is a very fast NPN transistor with a very shallow, high-gradient base profile. Any channelling along the sidewall of island 25b will be eliminated with the added concentration of P type impurity along the sidewall due to the $I_{CEO}$ implant. The emitter etch is typically 4 minutes or less to prevent the emitter from poking out in front of the base along the sidewall by removal of the field oxide 14b, 14c down to and below the base 25d.

While the above process does allow the formation of an in line sink but does not allow the formation of side-wall resistors as disclosed in Alter, United States Patent No. 4,149,177 and Berry, U.S. Patent No. 4,118,728, the structure is particularly suitable for use in the manufacture of fast RAMs and programmable PROMs capable of high manufacture yields. Although the device is emitter etch sensitive, the process does off a greater simplicity compared to one current standard oxide isolation process.

Because the diffused field predeposition is replaced with an ion implant, and nitride is used as a shadow mask to prevent the sidewall from being doped, vertical isolation is achieved whereby certain active regions of devices are separated from the underlying channel stop regions. Thus, the packing density of the device is improved. The rather shallow base implant for region 25d and the relatively high phosphorous pile-up along the intersection between the isolation oxide and the sidewalls 28a, 28b, 28c and 28d of silicon islands 25a, 25b thus achieves isolation by turning to advantage what previously was considered a disadvantage of oxide isolation techniques (the pile-up of phosphorous impurities in front of thermally grown oxide). In addition, the lateral PNP transistor as represented by emitter 25c and collector 25d with epitaxial material 15a (Figure 1) or 25a (Figure 2) serving as the base, replaces the previous non-active load resistor used in the circuit.

A PROM cell constructed in accordance with this invention is shown in Figure 4a. In Figure 4a, P type substrate 41 has formed in it N+ buried layer 42. Formed over the top surface of substrate 41 is an epitaxial layer with N type impurity concentration. From this N epitaxial layer, in a manner described above, has been formed an epitaxial region 43 comprising part of the collector of the device, a floating P type base region 44 and an N+ emitter region 45. Collector sink 46 is shown as a hard collector sink. In some situations sink 46 can be a soft collector sink depending upon the requirements of the memory cell. The advantage of the structure shown in Figure 4a is that only a collector contact and an emitter contact need be formed to the device thereby reducing the cell size by eliminating the base contact area. The structure shown in Figure 4a is formed in the manner described above in conjunction with the structures in Figures 2a through 2d with appropriate modifications to reflect the absence of the lateral transistor.

The process is suitable for use to form programmable read-only memories because the elimination of the field predeposition increases the NPN base-collector breakdown voltage of the structure. Prior art oxide isolated structures have a breakdown voltage of about 16 volts. By eliminating the diffusion in the sidewalls, the breakdown voltage from collector to base with emitter open ($BV_{CBO}$) is raised to 23 to 27 volts. This allows the structure to sustain the voltage necessary to destroy the base-emitter junction (between emitter 45 and base 44 in Figure 4a) because the current necessary to destroy the base-emitter junction depends upon the size of the emitter. By controlling the lateral dimensions of the semiconductor material comprising pocket 43, for example, and similar pockets, the emitter size can be controlled to an accuracy of $\pm 1/2$ μm by controlling the isolation oxide size. The emitter 45 is walled on four sides in the PROM memory cell application (no base contact is needed to the device because the base is allowed to float in this embodiment) and, therefore, when oxide encroachment is taken into account, a 6×6 micrometer silicon island 43 becomes, in the active device, about 2-1/2×2-1/2 microns in size. This reduction in size substantially increases the packing density achieved using the process of this invention and by decreasing chip size increases yield. By ensuring that $BV_{CBO}$ is roughly 23 to 27 volts, the curent sufficient to destroy the emitter-base junction can be generated in the structure. For a given value of beta and with higher $BV_{CBO}$, a higher $LV_{CEO}$ will result in accordance with the relation:

$$LV_{CEO}=BV_{CBO}/\eta\sqrt{beta}$$

where n=3 to 4 for silicon. In order to enhance $LV_{CEO}$, an extra mask and implant is utilized only in the memory cell to depress beta, thus raising $LV_{CEO}$. This aids in increasing programming yields for PROMs.

Use of <100> crystallographic silicon material is preferred because it eliminates what is called "epi shift", gives an isotropic "bird beak" and, therefore, allows better metal coverage and yields devices with better $I_{CEO}$ characteristics.

The vertical isolation is achieved by the use of N epitaxial material (1.5 to 3 ohms-cm) with no field predeposition along the sidewall. The P type base 25d formed in the N epitaxial layer is not allowed to reach the underlying P type 1-1/2 to 3 ohm-cm substrate, thus preventing leakage from the P type base to the P type substrate. For these epitaxial layer and substrate dopant concentrations, the substrate will not diffuse upward into the epitaxial layer since both dopant concentrations are approximately equal, i.e. about $1\times10^{+16}/cm^3$. However, a lower resistivity substrate (typically 0.4—0.6 ohm-cm) allows the P type impurity to diffuse upward into the epitaxial layer (about 0.6—0.7 µm) for 0.4—0.6 ohm-cm substrate) since the substrate dopant concentration now exceeds that of the epitaxial layer. When using a 1.5 micrometer thick epitaxial layer, this upward diffusion is sufficient to contact the lower portion of the base, thus ruining vertical isolation.

The lateral PNP base (Figure 2d) is reverse biased with respect to the substrate; therefore, parasitic hole injection occurs which is picked up in the substrate. This charge must be eliminated to prevent interference with the φ stack which is referenced above the substrate. Otherwise, the product made using this structure may suffer from "floating" φ stacks at high current injection and thus become unstable. Either a gold alloy through the back side of the wafer for contact or contact to the substrate via a ground tap P type implanted sinker from the top surface achieves this. The latter case requires an additional masking step.

In accordance with this invention, an active PNP cell can be made using one masking step. Using the process of this invention, epitaxial resistors are well-controlled because they are implanted. However, as epitaxial resistors become narrow, a problem can occur with critical dimensions. While the process makes a very good 6-micrometer wide resistor (which with oxide encroachment will reduce down to 2 micrometer wide) by using the latest state of the art photolithographic techniques, this resistor can be fabricated down to 1 micrometer wide after oxide encroachment.

The soft sink uses N epitaxial material as the sink. Because there is no field predeposition of impurities along the sidewalls of this sink, the soft sink can be made smaller by approximately 2 micrometer per dimension than prior art sinks because it will not be pinched off by the encroachment of the field predeposition impurities during oxidation.

Figure 2d illustrates in dashed line an optional embodiment wherein buried layer 22 terminating prior to contact with the left most field oxide 14a. The space 22a represents a PN junction between the P type substrate 11 and the N type epitaxial layer 25. During operation, P type region 25c is forward-biased relative to N type epitaxial layer portion 25a and thus the P type substrate 11 in combination with N type region 25a and P type region 25c acts as a transistor with possible substantial gain. To avoid this, buried layer 22 can, if desired, and indeed should in some applications, extend all the way into contact with the field isolation oxide 14a, as shown. Thus, buried layer 22 would contact and overwhelm a portion of P plus region 23a as shown in Figure 2d. Alternatively, in certain circuits, it is advantageous to have a substrate PNP device capable of producing substantial current. Should that be the case, buried layer 22 can be terminated at the dashed line as shown in Figure 2d.

In the PROM process, the yield in die per wafer has increased an average of about one order of magnitude as a result of use of this process.

Figure 4b shows the structure of Figure 4a in top view with, however, a modification wherein each collector sink 46, 46-1, 46-2 and 46-3 (Figures 4a and 4b) is used to provide electrical contact to two active devices rather than one active device. Thus, for example, collector sink C2 (46-2) makes electrical contact to the active devices including emitters E2 and E3 (numbered 45-2 and 45-3 in Figure 4b). Buried layer 42-2 allows electrical contact from collector sink 46-2 to the two devices containing emitters E2 and E3 underneath the isolation oxide 47 surrounding each of these two active devices. Oxide 47 defines the lateral extent of these devices.

Bit lines B1, B2, B3 and B4 are shown running vertically in the drawing. Bit lines B1 to B4 are formed on insulation over the surface of the device. Each bit line is electrically connected to those emitters underlying it through oxide cut contacts. For simplicity, these contacts are not shown in Figure 4b. The bit lines B1 to B4 comprise the first conducting layer on the structure. A second layer of insulation is then placed over bit lines B1 to B4 (which typically are fabricated from metal but could also be fabricated of other conductive material such as selectively doped polycrystalline silicon). On top of the second layer of insulation (typically a phosphorus doped silicon dioxide or silicon dioxide-silicon nitride composite layer) is formed a series of horizontal word lines. Word line W1 is shown in Figure 4b extending horizontally across the paper. Each word line contacts those collector regions underlying it through vias such as vias 49-1 through 49-3 as shown in Figure 4b.

The advantage of the structure shown in Figure 4b is that one collector sink serves two active devices, thereby eliminating half the collector sinks normally used in a PROM. Consequently, device packing density is improved. In another embodiment shown in Figure 4e, each sink (such as C1) contacts four active devices (such as E1, E2, E3 and E4), two on each side of the sink, thereby further improving packing density. In general, up to N active devices can be contacted by each sink, where N is a selected positive integer limited by the voltage drop acceptable in the circuit.

Another embodiment of this invention similarly improving packing density by using one collector sink to contact two or more active devices is illustrated in Figure 4c. Here the collector sink regions C1, C2 corresponding to region 46 in Figure 4a are shown arranged horizontally across the top portion of the drawing. Word line W1 extends horizontally across the structure electrically contacting the underlying sink regions through vias 59-1, 59-2.

The devices containing emitter regions E1 and E2 are electrically connected to the corresponding collector sink region C1 by a buried layer 42 (shown in isometric cut-away view in Figure 4d) underneath the isolation oxide 47 separating the emitter regions from the collector sink regions. Emitter regions E3 and E4 are electrically connected to collector sink region C2 by a buried contact layer similar to layer 42 shown in Figure 4d. Bit lines B1 to B4 are formed on insulation overlying the top surface of the structure and make contact to underlying emitter regions E1 to E4 through oxide cut contacts 60-1 through 60-4 formed through this insulation. Word line W1 is formed on insulation overlying bit lines B1 to B4.

An advantage of this invention is that the oxide cut contacts 60-1 to 60-4 can each overlie a portion of the field oxide 47 so long as a portion of each contact exposes the underlying emitter region. This allows a greater tolerance on the separation of the bit lines B1, B2, B3 and B4 than would otherwise be expected for a structure with as large a packing density as achieved with this structure. Each bit line contacts a plurality of underlying emitter regions associated with other cells in a manner such as described above for emitters E1 to E4 in Figure 4b.

Overlying the top surface of the structure including bit lines B1 to B4 is a second layer of insulation (typically a phosphorus doped silicon dioxide or a composite layer of silicon oxide and silicon nitride) and on this second layer of insulation are formed from the horizontal word lines for the memory of which word line W1 is shown in Figure 4c. Word line W1 contacts a plurality of underlying collector sinks shown as C1 and C2 in Fgure 4c through vias such as vias 59-1 and 59-2 as shown in Figure 4c. Each word line contacts the plurality of collector sinks formed beneath the word line through vias such as shown in Figure 4c.

Figure 4d shows an isometric cut-away view of a portion of the structure shown in Figure 4c along section 4d. Figure 4d shows the relationship of a P-type silicon substrate 41 to the other regions formed in the substrate. N+ buried layer 42 extends underneath emitter E1 and collector sink C1 as shown and similarly under emitter E2 (not shown). Field oxide 47 defines the lateral extent of emitter E1 and collector sink C1 on all sides. Buried contact layer 42 extends underneath field oxide 47 to connect electrically emitter E1 to collector sink C1. Collector sink C1 is a hard sink having been converted to N+ conductivity type from its normal N conductivity type. N epitaxial layer 43 has formed in it P type base region 44 to which no contact is formed and N+ emitter region 45 to which electrical contact is formed from the top surface of the structure as shown in top view in Figure 4c. Figure 4d illustrates clearly the fact that the lateral extents of the collector sink and the emitter regions are defined by the oxide region 47 and shows the important size reductions achievable by eliminating the base contact in the PROM cell. In programming the device, the PN junction between base region 44 and emitter region 45 is selectively avalanced to break down this junction in selected transistors in the PROM (which contains a plurality of cells of the type shown in Figure 4a) thereby to form a short circuit. The way in which this is done will be briefly described below.

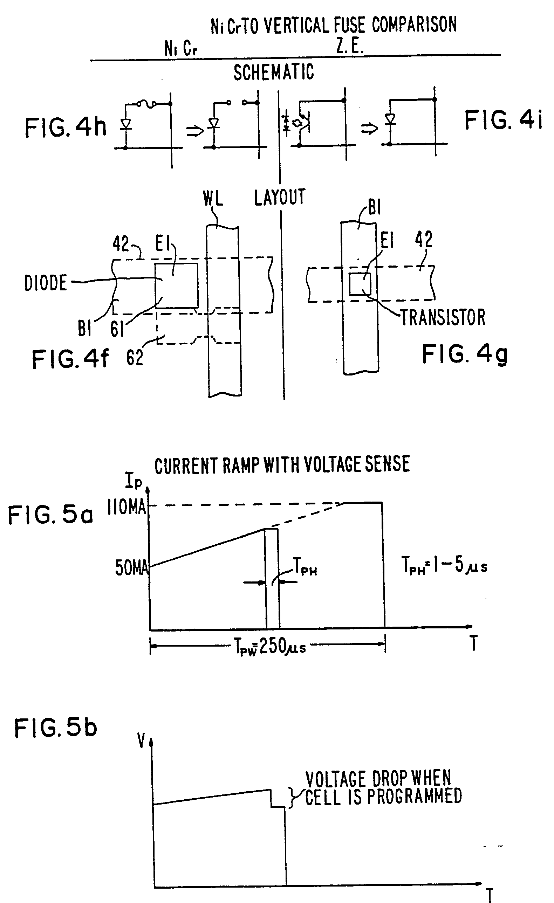

Figures 4f and 4g show the size reduction achievable by using the structure of this invention as compared to certain prior art NiChrome (nickel-chromium) structures. As shown in Figure 4f, the emitter region 61 is reasonably large and is attached to one end of a fuse link 62, the other end of which is attached to a bit line such as line B1. As an alternative, the emitter region 61 can be substituted by a base-collector diode or a Schottky. Typically bit line B1 is formed of a metal such as aluminum. In programming the cell, the fuse link 62 will either be left intact thereby leaving a short circuit, or blown, thereby creating an open circuit. The fuse linked together with the emitter region takes surface space and reduces packing density.

Figure 4g illustrates the compact structure of this invention wherein the bit line B1 is directly contacted to the underlying transistor emitter E1 through a contact cut. The bit line again is formed of a metal such as aluminum and the buried layer 42 provides electrical contact to the emitter region E1 from a collector sink (not shown for simplicity). A comparison between prior art (Figure 4f) and the vertical fuse structure (Figure 4g) illustrates the substantial savings in space for this invention.

Figures 4h and 4i illustrate the circuits resulting from programming the structures of Figures 4f and 4g, respectively.

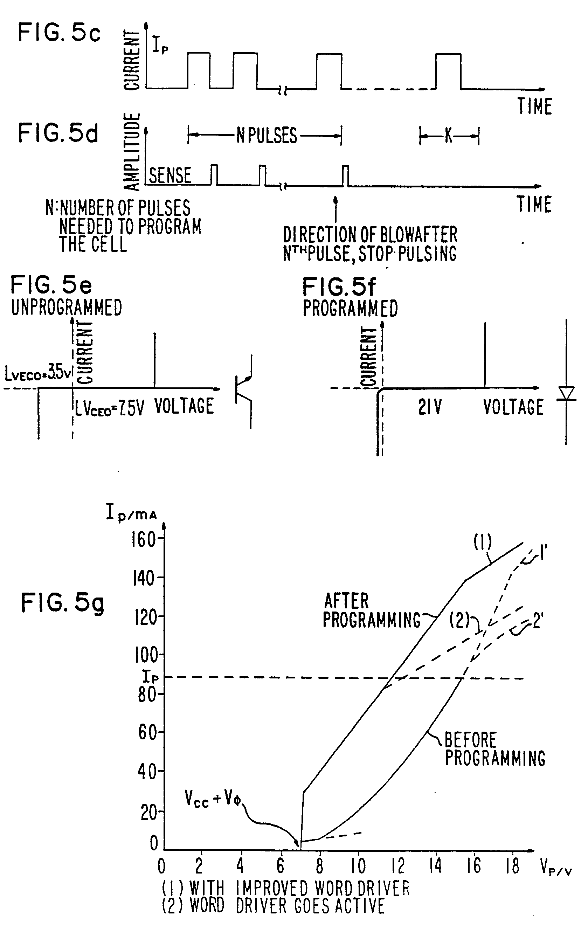

The programming procedure for programming the PROM cell of this invention is illustrated in Figures 5a through 5f. In Figure 5a, the programming current as a function of time is illustrated for use with the "vertical fuse" (i.e. short-circuited or "blown") emitter structure shown, for example, in Figures 4a through 4g. The optimum programming process is one which is insensitive to design and process variations on the product and which delivers the optimum amount of power to the cell to be programmed. At the same time, the programming structure and method must be sensitive to the avalanching of the emitter-base junction so as to minimize damage to the base-collector junction of the device being programmed. Accordingly, the current source used to deliver the programming power must reduce power after the avalanching of the junction and must automatically shut off power after the cell has been "programmed" (i.e., the emitter-base junction destroyed) with a selected delay time. If during programming the base collector junction of a cell is damaged, then leakage may occur through that cell when another cell is being read. Typically the leakage path goes from the bit line attached to the selected cell through to the word line attached to a non-selected or "de-selected" cell, through the damaged base collector junction of this de-selected cell to the bit line attached to this de-selected cell and then through another cell attached to the word line connected to the selected cell. Naturally, this leakage is undesirable. A similar leakage path is generated by an abnormally low $LV_{CEO}$ in a de-selected cell. Again, this leakage path is undesirable (this leakage can prevent proper programming of the PROM) and thus proper device processing to prevent low $LV_{CEO}$ in a cell is essential to avoid the identical type of leakage to that caused by a damaged base-collector junction.

In selecting the programming technique, the advisability of using constant current pulses of selected with was considered. Unfortunately, a constant width pulse sometimes results in base-collector junction damage of certain cells because the current required to program a cell is a function of the cell parameters such as emitter-base junction area and cell characteristics. Accordingly, it was discovered that a constant current pulse of a selected width gave poorer programming yields than desired. It was concluded that each cell needs different programming voltage because of the expected variations in cell parameters. Thus, using a constant current source pulse of selected width requires frequent adjustments of the width of the current source pulse and its amplitude.

A variable width constant current cell wherein the pulse width was adjusted according to the requirements of each cell yielded good base-collector junctions. However, if the base-emitter junction was destroyed at the rising edge of the pulse the detection of the blowing of this junction is difficult. Moreover, the programming current required was dependent on design and process variations. Accordingly, it was decided to program each cell with a current source ramping up in time. The duration of the ramping current pulse was variable, depending upon when the emitter-base junction blew out. The ramping current source made possible easy detection of the blowing of this junction. The programming current using this technique is self-adjusting to the needs of each cell. The result is a high programming yield and high reliability of both the programming method and the resulting programmed memory.

A current ramp used in conjunction with a voltage sense circuit (of well-known design and thus not described) is illustrated in Figures 5a and 5b. As shown in Figure 5a, the current ramps up for a selected time until a drop in voltage is noted across the cell. A voltage sense circuit detects this drop in voltage across the cell and maintains the current from the current source for a small additional time $T_{ph}$ which varies from 1 to 5 microseconds and then shuts off the current source. The maintenance of the current for this additional time $T_{ph}$ ensures a low resistance programmed cell and at the same time optimizes the power devoted to each cell, thus minimizing the likelihood that the base-collector junction of the programmed cell will be damaged. This minimizes the possible occurrence of leakage through the programmed cell when this cell is a de-selected cell connected in the manner described above.

Another useful technique for programming each cell also uses a series of current pulses as illustrated in Figure 5c. The current pulses are generated until a given cell is programmed. The total current through the cell is a function of the cell parameters. Following the detection of the blowing of the emitter-base by the application of a sequence of sense pulses wherein one sense pulse occurs following each current pulse, additional K current pulses are provided to ensure low resistance in the programmed cell but not for such a period of time as to damage the base-collector junction. The number of pulses needed to program each cell varies depending upon the characteristics of each cell.

Figures 5e and 5f illustrate the memory cell electrical characteristics in the unprogrammed and programmed state, respectively. As noted in Figure 5e, the $LV_{CEO}$ of the cell is about 7.5 volts when the cell is not programmed. When the emitter-base junction is destroyed, the back voltage across the diode becomes about 21 volts or greater, corresponding to the voltage breakdown across a collector-base junction using recessed oxide of the type described above in conjunction with Figures 2a—2d. On the other, the forward bias voltage across the junction is merely about 0.6 to 0.7 volts and the unprogrammed reverse-biased voltage from emitter to collector with the base open is about 3.5 volts as illustrated in Figure 5e.

Figure 5g illustrates the programming path I—V curve. As shown in Figure 5g, the current voltage path before programming compared to the current voltage path after programming exhibits hysteresis such that after programming the I—V path is displaced substantially to the left on the curve. The programming curve $I_p$ is that current at which the cell programs. Once the cell has been programmed, the voltage across the cell drops drastically from about 9 volts as illustrated in Figure 5g to about 15 volts. This plot illustrates the importance of ensuring that $LV_{CEO}$ be greater than 9 volts and, as described above, preferably in excess of 12—15 volts to ensure adequate tolerance for the programming of each cell in the array without exceeding $LV_{CEO}$.

Among the advantages of the above-described process compared to the prior art processes, is the elimination of the boron tube and the low temperature oxidation cycle, the omission of the base drive step and the elimination of certain mask making steps. In addition, a field implant is used instead of a field predeposition followed by low temperature oxidation. The additional process steps include an $I_{CEO}$ implant to prevent collector to emitter leakage, and, when PROMS are being made, an additional implant to improve $LV_{CEO}$.

In the manufacture of the structure of this invention, an additional advantage is obtained by removing those portions of silicon nitride and silicon oxide layers 24a and 26a (Figure 2a) in such a manner that the silicon dioxide layer 24a is removed as shown in Figure 2a underneath the lateral extremities of silicon nitride layer 26a. This is done by etching away prior to silicon etch portions of the silicon dioxide layer 24a underneath the lateral extremities of the silicon nitride layer after having patterned silicon nitride layer 26a to expose the regions of epitaxial silicon 25 to be removed to form grooves 27a, 27b and 27c. A buffered HF etchant (buffered with ammonium fluoride) is used for this and the wafer is placed in this etchant for times varying from one to eight minutes. Then portions of the epitaxial layer 25 exposed by removal of the silicon dioxide and silicon nitride are etched using a standard silicon etchant (such as an iodine buffered mixture of acetic, nitric and HF acids) to leave a plurality of islands of semiconductor material. The epitaxial silicon is removed laterally beneath the overhangs of the silicon nitride thereby to form sidewalls on the silicon islands recessed beneath the overhangs of the nitride layer 26a by the amount of the removed silicon dioxide. Surprisingly, the sidewall angle is substantially the same (about 57°) as when the silicon is etched without removal of substantial silicon dioxide. Then the channel stop regions are formed in the bottoms of the grooves 27a, 27b and 27c, laterally displaced from the silicon islands an additional amount determined by the overhang of phe silicon nitride layer 26a over the silicon dioxide layer 24a, thereby to prevent the channel stop regions from laterally diffusing to the silicon islands during subsequent processing of the wafer.

**Claims**

1. Semiconductor structure comprising:
a substrate (41 in Figures 4b, 4d) of a first conductivity type having an upper surface;
an epitaxial layer (43 in Figures 4b, 4d) of a second conductivity type, opposite to the first conductivity type, formed on the upper surface of the substrate;
a laterally extending PN isolation junction formed between the epitaxial layer and the substrate;
vertical portions of the epitaxial layer (43) being oxidized through the epitaxial layer to the PN isolation junction so that a plurality of islands of semiconductor material from the epitaxial layer is formed, with each island being isolated from the other islands by the oxidized vertical portions of the epitaxial layer and by the laterally extending PN isolation junction;
the structure comprising:
a plurality of vertical transistors, each formed in one of the islands of semiconductor material in the epitaxial layer, each such transistor having an emitter region (45 in Figures 4b, 4d) of second conductivity type adjacent to the top surface of the epitaxial layer (43); a base region (44 in Figures 4b, 4d) of first conductivity type positioned below the emitter region, and a collector region (42/43 in Figures 4b, 4d) of second conductivity type positioned below the base region, with PN junctions being formed between the emitter and base regions and between the base and collector regions, with each emitter region having a first electrical contact means (E1 in Figure 4d) and each collector region (C1 in Figure 4d) having a second electrical contact means;
wherein each base region and each emitter-base junction has its lateral dimensions defined completely by the oxidized portions of the epitaxial layer;
wherein each base region has a portion directly adjacent to the oxidized portions of the epitaxial layer that is implanted with ions of first conductivity type and of predetermined concentration profile, thereby to increase the collector-emitter breakdown voltage with base open, $LV_{CEO}$, of one or more of the vertical transistors;
wherein selected ones among the plurality of vertical transistors may be altered by having their base-emitter junctions destroyed to form an electrical circuit between emitter and base so that each altered transistor represents a second, different state of information, whereby the structure comprises a programmable read-only memory.

2. The structure of Claim 1, characterized in that the regions of each of said transistors are formed in the base regions of said transistors such that only the leading edge of each base region protrudes past each emitter region, thereby to yield a shallow base with a high dopant concentration gradient for fast transit times in said transistors.

3. Structure as in Claim 1, characterized in that said second electrical contact means for contacting said collector region comprises a buried contact region of the same conductivity type as said epitaxial layer but of higher dopant concentration than said epitaxial layer, the buried contact region being formed in said substrate directly beneath said epitaxial layer and extending partially into said epitaxial layer, the buried contact region extending laterally underneath an oxidized portion of said epitaxial layer into contact with at least two of said islands of semiconductor material formed from said epitaxial layer, each of said islands of semiconductor material comprising a contact region extending to the top surface of said epitaxial layer, thereby to allow contact to be made to said collector region.

4. Structure as in Claim 3, characterized in that each of said islands of semiconductor material includes a top region of second conductivity type but of a higher impurity concentration than said epitaxial layer.

5. Structure as in Claim 1, characterized in that said second electrical contact means for contacting said collector region comprises a multiplicity of islands of semiconductor material defined by said oxidized portions of said epitaxial layer, each of said islands of semiconductor material being connected by a buried contact region formed in said underlying substrate and extending into said epitaxial layer, and extending from said island of semiconductor material to said collector regions of N of said vertical transistors formed in adjacent islands of semiconductor material defined by oxidized portions of said epitaxial layer, where N is a selected positive integer, thereby to reduce the number of islands of semiconductor material used to contact said collector regions of said plurality of transistors, and thus to increase the packing density of said structure.

6. Structure as in Claim 5, characterized in that said integer N is 4.

7. Structure as in Claim 5, characterized in that said integer N is 2.

8. Structure as in Claim 5, characterized by including a selected number of bit information lines, arranged parallel to one another, with each bit line overlying and making electrical contact to the emitter regions of a selected number of said vertical transistors; and

wherein said structure includes a multiplicity of information word lines that are substantially orthogonal to the bit lines, each of the word lines being insulated from the bit lines and overlying and making electrical contact to a selected number of said second electrical contact means for contacting said collector regions;

whereby said structure comprises a programmable read-only memory.

9. A method of forming a semiconductor device, the method comprising the steps of:

providing a substrate of a first conductivity type having an upper surface;

providing an epitaxial layer of a second conductivity type, opposite to the first conductivity type, formed on the upper surface of the substrate and having an upper surface;

forming a laterally extending PN isolation junction between the epitaxial layer and the substrate;

thermally oxidizing vertical portions of the epitaxial layer from the top surface thereof to the PN isolation junction so that a plurality of islands of semiconductor material from the epitaxial layer is formed, with each island being isolated from the other islands by the oxidized vertical portions of the epitaxial layer and by the laterally extending PN isolation junction;

the method further comprising the steps of:

providing a plurality of vertical transistors, each such transistor being formed in one of the islands of semiconductor material in the epitaxial layer, with each such transistor having an emitter region of second conductivity type adjacent to the upper surface of the epitaxial layer, having a base region of first conductivity type positioned below the emitter region, and having a collector region of second conductivity type positioned below the base region, with a PN junction being formed between the emitter region and the base region of each such transistor and a PN junction being formed between the base region and collector region for each such transistor, with each such emitter region having a first electrical contact means connected thereto and each collector region having a second electrical contact means connected thereto, wherein each such base region and each such emitter-base PN junction has its lateral dimensions defined completely by the oxidized portions of the epitaxial layer;

implanting ions of first conductivity type and of predetermined concentration profile in a portion of each base region that is directly adjacent to oxidized portions of the epitaxial layer, thereby to increase the collector-emitter breakdown voltage with base open, $LV_{CEO}$, of one or more of the vertical transistors;

altering selected transistors among the plurality of vertical transistors by destroying the base-emitter junction of each such selected transistor to form an electrical circuit between emitter and base so that each altered transistor represents a first state of information and each unaltered transistor represents a second, different state of information, whereby the structure comprises a programmable read-only memory.

10. The method of Claim 9, characterized by including the steps of

formation of said base region in each of said vertical transistors so that only the leading edge of each said base region protrudes past each said emitter region of said vertical transistor, thereby to provide a shallow base region with a high dopant concentration gradient with small associated transit times in said vertical transistor.

11. The method of Claim 9, characterized by including the steps of:

providing said second electrical contact means as a buried contact region of second conductivity type and of higher dopant concentrations than said epitaxial layer, the buried contact region being formed in said substrate directly beneat said epitaxial layer and extending partially into said epitaxial layer, the buried contact region extending laterally underneath at least one of said oxidized portions of said epitaxial layer to provide electrical contact between at least two of said islands of semiconductor material formed in said epitaxial layer, with each of said islands of semiconductor material comprising a contact region extending to the top surface of said epitaxial layer, thereby to allow contact to be made to said collector region.

12. The method of Claim 9, characterized by including the steps of:

providing an uppermost portion of each of said islands of semiconductor material in said epitaxial layer as second conductivity type but having a higher impurity concentration than does said epitaxial layer.

13. The method of Claim 9, characterized by including the steps of:

providing a selected number of bit information lines, arranged parallel to one another, with each bit line overlying and making electrical contact to said emitter region of each of a selected number of said vertical transistors; and

providing a plurality of information word lines that are substantially orthogonal to the information bit lines, with each word line being insulated from each bit line and each word line overlying and making electrical contact to a selected number of said second electrical contact means for contacting selected collector regions.

**Patentansprüche**

1. Halbleiteranordnung, umfassend:

ein Substrat (41 in Fig. 4b, 4d) eines ersten Leitfähigkeitstyps mit einer oberen Oberfläche;

eine Epitaxialschicht (43 in Figure 4b, 4d) eines zweites Leitfähigkeitstyps entgegengesetzt dem ersten Leitfähigkeitstyp, ausgebildet auf der oberen Oberfläche des Substrats;

eine sich seitlich erstreckende PN-Isolationssperrschicht, ausgebildet zwischen der Epitaxialschicht und dem Substrat;

wobei vertikale Abschnitte der Epitaxialschicht (43) durch die Epitaxialschicht zu der PN-Isolationssperrschicht oxidiert sind, so daß eine Mehrzahl von Halbleitermaterialinseln aus der Epitaxialschicht gebildet wird, jede Insel von den anderen Inseln durch die oxidierten vertikalen Abschnitte der Epitaxialschicht und durch die sich seitlich erstreckende PN-Isolationssperrschicht isoliert;

welche Anordnung umfaßt;

eine Mehrzahl von vertikalen Transistoren, jeder ausgebildet in einer der Halbleitermaterialinseln in der Epitaxialschicht, wobei jeder solche Transistor einen Emitterbereich (45 in Fig. 4b, 4d) des zweiten Leitfähigkeitstyps nahe der Deckoberfläche der Epitaxialschicht (43) aufweist; einen Basisbereich (44 in Fig. 4b, 4d) des ersten Leitfähigkeitstyps unter dem Emitterbereich, und einen Kollektorbereich (42/43 in Fig. 4b, 4d) des zweiten Leitfähigkeitstyps, positioniert unter dem Basisbereich, wobei PN-Übergänge zwischen dem Emitterbereich und dem Basisbereich sowie zwischen dem Basisbereich und em Kollektorbereich ausgebildet sind und wobei jeder Emitterbereich ein erstes elektrisches Kontaktmittel (E1 in Fig. 4d) und jeder Kollektorbereich (C1 in Fig. 4d) ein zweites elektrisches Kontaktmittel aufweist;

wobei jeder Basisbereich und jeder Emitter-Basis-Übergang hinsichtlich seiner seitlichen Abmessungen vollständig durch die oxidierten Abschnitte der Epitaxialschicht begrenzt ist;

wobei jeder Basisbereich unmittelbar an den oxidierten Abschnitten der Epitaxialschicht einen Abschnitt aufweist, der mit Ionen des ersten Leitfähigkeitstyps und vorgegebenem Konzentrationsprofil implantiert ist, um so die Kollektor-Emitter-Durchbruchspannung bei offener Basis, $LV_{CEO}$, eines oder mehrerer der vertikalen Transistoren zu erhöhen;

wobei unter der Mehrzahl vertikaler Transistoren ausgewählte veränderbar sind durch Zerstörenlassen ihrer Basis-Emitter-Übergänge zur Bildung eines elektrischen Kreises zwischen Emitter und Basis, so daß jeder geänderte Transistor einen zweiten abweichenden Informationszustand repräsentiert, wodurch die Anordnung einen programmiebaren Festwertspeicher umfaßt.

2. Die Anordnung nach Anspruch 1, dadurch gekennzeichnet, daß die Bereiche jedes der genannten Transistoren in den Basisbereichen der genannten Transistoren derart ausgebildet sind, daß nur die führende Kante jedes Basisbereichs hinter jeden Emitterbereich hinausragt, um so eine flache Basis zu ergeben mit einem hohen Störstellenkonzentrationsgradienten für schnelle Übergangszeiten in den genannten Transistoren.

3. Anordnung nach Anspruch 1, dadurch gekennzeichnet, daß das zweite elektrische Kontaktmittel für das Kontaktieren des Kollektorbereichs einen vergrabenen Kontaktbereich gleichen Leitfähigkeitstyps wie die genannte Epitaxialschicht, jedoch von höherer Störstellenkonzentration als die Epitaxialschicht umfaßt, welcher vergrabene Kontaktbereich in dem Substrat unmittelbar unter der genannten Epitaxialschicht ausgebildet ist und sich teilweise in die Epitaxialschicht erstreckt, welcher vergrabene Kontaktbereich sich seitlich unter einen oxidierten Abschnitt der genannten Epitaxialschicht erstreckt in Kontakt mit mindestens zwei der aus der Epitaxialschicht gebildeten Halbleitermaterialinseln, wobei jede der genannten Halbleitermaterialinseln einen Kontaktbereich umfaßt, der sich zur Deckfläche der Epitaxialschicht erstreckt, um so die Kontaktierung des genannten Kollektorbereichs zu ermöglichen.

4. Anordnung nach Anspruch 3, dadurch gekennzeichnet, daß jeder der Halbleitermaterialinseln einen Deckbereich des zweiten Leitfähigkeitstyps, jedoch höherer Störstellenkonzentration als die Epitaxialschicht, umfaßt.

5. Anordnung nach Anspruch 1, dadurch gekennzeichnet, daß das genannte zweite elektrische Kontaktmittel für das Kontaktieren des genannten Kollektorbereichs eine Mehrzahl von Halbleitermaterialinseln, begrenzt von den genannten oxidierten Abschnitten der Epitaxialschicht, umfaßt, wobei jede der genannten Halbleitermaterialinseln verbunden ist durch einen vergrabenen Kontaktbereich, ausgebildet in dem unterliegenden Substrat und sich in die genannte Epitaxialschicht erstreckend, und sich von der genannten Halbleitermaterialinsel zu den genannten Kollektorbereich von N der genannten vertikalen Transistoren erst reckt, ausgebildet in benachbarten Halbleitermaterialinseln, begrenzt von oxidierten Abschnitten der genannten Epitaxialschicht, wobei N eine ausgewählte positive ganze Zahl ist, um so die Anzahl von Halbleitermaterialinseln zu verringern, die zum Kontaktieren der genannten Kollektorbereiche der genannten Mehrzahl von Transistoren benutzt werden, und damit die Packungsdichte der Anordnung zu vergrößern.

6. Anordnung nach Anspruch 5, dadurch gekennzeichnet, daß die genannte ganze Zahl N=4 beträgt.

7. Anordnung nach Anspruch 5, dadurch gekennzeichnet, daß die genannte ganze Zahl N=2 beträgt.

8. Anordnung nach Anspruch 5, gekennzeichnet, durch das Umfassen einer ausgewählten Anzahl von parallel zueinander angeordneten Bit-Informationsleitungen, wobei jede Bit-Leitung die Emitterbereiche einer ausgewählten Anzahl der genannten vertikalen Transistoren überlagert und kontaktiert; und

wobei die Anordnung eine Mehrzahl von Informations-Wort-Leitungen umfaßt, die im wesentlichen senkrecht zu den Bitleitungen verlaufen, wobei jede der Wort-Leitungen von den Bit-Leitungen isoliert ist, eine ausgewählte Anzahl der genannten zweiten elektrischen Kontaktmittel überlagert und kontaktiert, um die genannten Kollektorbereiche zu kontaktieren;

wodurch die Anordnung einen programmierbaren Festwertspeicher umfaßt.

9. Ein Verfahren zum Ausbilden einer Halbleiteranordnung, welches Verfahren die Schritte umfaßt:

Bereitstellen eines Substrats eines ersten Leitfähigkeitstyps mit einer oberen Oberfläche;

Bereitstellen einer Epitaxialschicht eines zweiten, dem ersten entgegengesetzten Leitfähigkeitstyps, ausgebildet auf der oberen Oberfläche des Substrats und eine obere Oberfläche aufweisend;

Bilden einer sich seitliche erstreckenden PN-Isolationssperrschicht zwischen der Epitaxialschicht und dem Substrat;

thermisches Oxidieren vertikaler Abschnitte der Epitaxialschicht von deren Deckfläche zur PN-Isolationssperrschicht, so daß eine Mehrzahl von Halbleitermaterialinseln aus der Epitaxialschicht gebildet wird, wobei jede Insel von den anderen Inseln durch die oxidierten Abschnitte der Epitaxialschicht und durch die sich seitlich erstreckende PN-Isolationssperrschicht isoliert ist;

welches Verfahren ferner die Schritte umfaßt:

Vorsehen einer Mehrzahl vertikaler Transistoren, wobei jeder solche Transistor in einer der Halbleitermaterialinseln in der Epitaxialschicht ausgebildet wird, wobei jeder solche Transistor einen Emitterbereich des zweiten Leitfähigkeitstyps an der oberen Oberfläche der Epitaxialschicht hat, einen Basisbereich des ersten Leitfähigkeitstyps unter dem Emitterbereich positioniert hat, und einen Kollektorbereich des zweiten Leitfähigkeitstyps unter dem Basisbereich positioniert hat, wobei ein PN-Übergang zwischen dem Emitterbereich und dem Basisbereich jedes Transistors und ein PN-Übergang zwischen dem Basisbereich und dem Kollektorbereich für jeden solchen Transistor gebildet wird, wobei jeder solche Emitterbereich mit einem ersten elektrischen Kontaktmittel verbunden ist und jeder Kollektorbereich mit einem zweiten elektrischen Kontaktmittel verbunden ist, wobei jeder solche Basisbereich und jeder solche Emitter-Basis-PN-Übergang seine seitlichen Abmessungen vollständig durch die oxidierten Abschnitte der Epitaxialschicht begrenzt hat;

Implantieren von Ionen des ersten Leitfähigkeitstyps und vorgegebenen Konzentrationsprofils in einen Abschnitt jedes Basisbereichs, der direkt nahe oxidierten Abschnitten der Epitaxialschicht liegt, wodurch die Kollektor-Emitter-Durchbruchspannung bei offener Basis, $LV_{CEO}$, eines oder mehrerer vertikaler Transistoren vergrößert wird;

Verändern ausgewählter Transistoren unter der Mehrzahl der vertikalen Transistoren durch Zerstören des Basis-Emitter-Übergangs jedes solchen ausgewählten Transistors zum Bilden eines elektrischen Kreises zwischen Emitter und Basis, so daß jeder veränderte Transistor einen ersten Informationzustand repräsentiert und jeder ungeänderte Transistor einen zweiten, abweichenden Informationszustand repräsentiert, wodurch die Anordnung einen programmierbaren Festwertspeicher umfaßt.

10. Das Verfahren nach Anspruch 9, gekennzeichnet, durch das Umfassen der Schritte:

Bilden der Basisbereiche in jedem der genannten vertikalen Transistoren derart, daß nur die führende Kante jedes genannten Basisbereichs hinter jeden genannten Emitterbereich des genannten vertikalen Transistors hinausragt, um so einen flachen Basisbereich mit einem hohen Störstellenkonzentrationsgradienten und mit zugeordneten kleinen Übergangszeiten in dem genannten vertikalen Transistor zu schaffen.

11. Das Verfahren nach Anspruch 9, gekennzeichnet durch das Umfassen der Schritte:

Vorsehen des genannten zweiten elektrischen Kontaktmittels als einen vergrabenen Kontaktbereich zweiten Leitfähigkeitstyps und höheren Störstellenkonzentrationen als die genannte Epitaxialschicht, welcher vergrabene Kontaktbereich in dem Substrat unmittelbar unter der genannten Epitaxialschicht ausgebildet wird und sich teilweise in die genannte Epitaxialschicht erstreckt, welcher vergrabene Kontaktbereich sich seitlich unter mindestens einen der genannten oxidierten Abschnitte der genannten Epitaxialschicht erstreckt zum Herstellen des elektrischen Kontakts zwischen mindestens zwei der genannten, in der genannten Epitaxialschicht ausgebildeten Halbleitermaterialinseln, wobei jede der Halbleitermaterialinseln einen Kontaktbereich umfaßt, der sich zur Deckfläche der genannten Epitaxialschicht erstreckt, um so das Kontaktieren des genannten Kollektorbereiches zu ermöglichen.

12. Das Verfahren nach Anspruch 9, gekennzeichnet, durch das Umfassen der Schritte:

Ausbilden eines obersten Abschnitts jeder der genannten Halbleitermatrialinseln in der genannten Epitaxialschicht als zweiter Leitfähigkeitstyp, jedoch mit höherer Störstellenkonzentration als die der genannten Epitaxialschicht.

13. Das Verfahren nach Anspruch 9, gekennzeichnet, durch das Umfassen der Schritte:

Vorsehen einer ausgewählten Anzahl von parallel zueinander angeordneten Bit-Informations-Leitungen, von denen jede der genannten Emitterbereich jedes von einer ausgewählten Anzahl der genannten vertikalen Transistoren überlagert und kontaktiert; und

Vorsehen einer Mehrzahl von Informations-Wort-Leitungen, die im wesentlichen senkrecht zu den Informations-Bit-Leitungen sind, wobei jede Wort-Leitung von jeder Bit-Leitung isoliert ist und jede Wort-Leitung eine ausgewählt Anzahl der genannten zweiten elektrischen Kontaktmittel überlagert und kontaktiert, um ausgewählte Kollektorbereich zu kontaktieren.

## Revendications

1. Structure semi-conductrice comprenant:

un substrat (41 aux figures 4b, 4d) d'un premier type de conductivité ayant une surface supérieure;

une couche épitaxiale (43 aux figures 4b, 4d) d'un second type de conductivité, opposé au premier type de conductivité, formée sur la surface supérieure du substrat;

une jonction isolante PN s'étendant latéralement, formée entre la couche épitaxiale et le substrat;

des parties verticales de la couche épitaxiale (43) étant oxydére à travers la couche épitaxiale jusqu'à la jonction isolante PN de sorte qu'une pluralité d'îles en un matériau semi-conducteur est formée à partir de la couche épitaxiale, chaque île étant isolée des autres îles par les parties verticales oxydées de la couche épitaxiale et par la jonction isolante PN s'étendant latéralement;

La structure comprenant:

une pluralité de transistors verticaux, chacun formé dans une des îles en matériau semi-conducteur dans la couche épitaxiale, chacun des ces transistors ayant une région d'émetteur (45 aux figurs 4b, 4d) du second type de conductivité, adjacente à la surface supérieure de la couche épitaxiale (43);

une région de base (44 aux figurs 4b et 4d) du premier type de conductivité, disposée en dessous de la région d'émetteur, et une région de collecteur (42/43 aux figures 4b, 4d) du second type de conductivité, disposée en dessous de la région de base, des jonctions PN étant formées entre les régions d'émetteur et de base et entre les régions de base et de collecteur, chaque région d'émetteur ayant des premiers moyens de contact électrique (E1 à la figure 4d) et chaque région de collecteur (C1 à la figure 4d) ayant des seconds moyens de contact électrique;

chaque région de bas et chaque jonction émetteur-base ayant ses dimensions latérales définies complètement par les parties oxydées de la couche épitaxiale;

chaque région de base ayant une partie directement adjacente aux parties oxydées de la couche épitaxiale qui est implantée avec des ions du premier type de conductivité et d'un profil de concentration prédéterminée, augmentant ainsi la tension de claquage collecteur-émetteur à base ouverte, $LV_{CEO}$ d'un ou plusieurs des transistors verticaux;

des transistors sélectionnés parmi la pluralité de transistors verticaux peuvent être modifiés en ayant leur jonction base-émetteur détruite pour former un circuit électrique entre l'émetteur et la base de sorte chaque transistor modifié représente un second état l'information différent, la structure comprenant ainsi une mémoire morte programmable.

2. Structure selon la revendication 1 caractérisée en ce que les régions de chacun desdits transistors sont formées dans les régions de base desdits transistors de sorte que seulement le bord avant de chaque région de base fasse saillie au-délà de chaque région d'émetteur, rendant ainsi une base péu profonde avec un gradient élevé de concentration en dopant pour des temps de transits rapides dans lesdits transistors.

3. Structure selon la revendication 1 caractérisée en ce que lesdits seconds moyens de contact électrique pour mettre en contact ladite région de colleteur comprennent une région de contact noyée de même type de conductivité que ladite couche épitaxiale, mais d'une concentration en dopant plus élevée que ladite couche épitaxiale, la région de contact noyée étant formée dans ledit substrat directement au-dessous de ladite couche épitaxiale et s'étendant partiellement à l'intérieur de ladite couche épitaxiale, la région de contact noyée s'étendant latéralement au-dessous d'une partie oxydée de ladite couche épitaxiale en contact avec au moins deux desdites îles en matériau semi-conducteur formées à partir de ladite couche épitaxiale, chacune desdites îles en matériau semi-conducteur comprenant une région de contact s'étendant jusqu'à la surface supérieure de ladite couche épitaxiale, permettant ainsi de réaliser un contact avec ladite région de collecteur.

4. Structure selon la revendication 3 caractérisée en ce chacune desdites îles en matériaux semi-conducteur comprend une région supérieure du second type de conductivité mais d'une concentration en impuretés plus élevée que ladite couche épitaxiale.

5. Structure selon la revendication 1 caractérisée en ce que lesdits seconds moyens de contact électrique pour mettre en contact ladite région de collecteur comprennent une multiplicité d'îles en matériau semi-conducteur, définies par lesdites parties oxydées de ladite couche épitaxiale, chacune desdites îles en matériau semi-conducteur étant reliée par une région de contact noyée, formée dans ledit substrat sous-jacent et s'étendant dans ladite couche épitaxiale et s'étendant à partir de ladite île en matériau semiconducteur jusqu'auxdites régions de collecteur de N desdits transistors verticaux formés dans des îles adjacentes en matériau semi-conducteur définies par des parties oxydées de ladite couche épitaxiale, N étant un nombre entier positif déterminé, réduisant ainsi le nombre d'îles en matériau semi-conducteur utilisées pour mettre en contact lesdites régions de collecteur de ladite pluralité de transistors et augmentant ainsi la densité d'enregistrement de ladite structure.

6. Structure selon la revendication 5, caractérisée en ce que ledit nombre entier N est 4.

7. Structure selon la revendication 5, caractérisée en ce que ledit nombre entier N est 2.

8. Structure selon la revendication 5, caractérisée en par le fait qu'elle comprend un nombre déterminé de lignes de bit d'information disposées parallèlement les unes par rapport aux autres, chaque ligne de bit recouvrant et faisant un contact électrique avec les régions d'émeteur d'une nombre déterminé desdits transistors verticaux, ladite structure comprenant une pluralité de lignes de mot d'information qui sont sensiblement perpendiculaires aux lignes de bit, chacune des lignes de mot étant isolée des lignes de bit et recouvrant et faisant une contact électrique avec un nombre déterminé desdits seconds moyens de contact électrique pour mettre en contact lesdites régions de collecteur;

ladite structure comprenant, ainsi une mémoire morte.

9. Procédé pour former un dispositif semi-conducteur, le procédé comprenant les étapes consistant à réaliser un substrat d'un premier type de conductivité ayant une surface supérieure,

à fournir une couche épitaxiale d'un second type de conductivité opposé au premier type de conductivité, formée sur la surface supérieure du substrat et ayant une surface supérieure;

à former des jonctions isolantes PN s'étendant latéralement entre la couche épitaxiale et le substrat;

à oxyder thermiquement des parties verticales de la couche épitaxiale à partir de la surface supérieure de celle-ci jusqu'à la jonction isolante PN de sorte qu'une pluralité d'îles en matériaux semi-conducteur soit à partir formée de la couche épitaxiale, chaque îles étant isolée des autres îles par les parties verticales oxydées de la couche épitaxiale et par la jonction isolante PN s'étendant latéralement;

le procédé comprenant en outre les étapes consistant:

à réaliser une pluralité de transistors verticaux, chacun desdits transistors étant formé dans une des îles en matériau semi-conducteur dans la couche épitaxiale, chacun des ces transistors ayant une région d'émetteur du second type de conductivité adjacente à la surface supérieure de la couche épitaxiale, ayant une région de base du premier type de conductivité disposée, au-dessous de la région d'émetteur, et ayant une région de collecteur du second type de conductivité disposée au-dessous de la région de base, une jonction Pn étant formée entre la région d'émetteur et la région de base de chacun desdits transistors et une jonction PN étant formée entre la région de base et la région de collecteur pour chacun desdits transistors, chacune desdites région d'émetteur ayant des premiers moyens de contact électrique qui lui sont reliés et chaque région de collecteur ayant des seconds moyens de contact électrique qui lui sont reliés chacun des ces régions de base et chacune de ces jonctions PN émetteur-base ayant ses dimensions latérales définies complètement par les parties oxydées de la couche épitaxiale;

à implanter des ions du premier type de conductivité et d'un profile de concentration prédéterminée dans une partie de chaque région de base qui est directement adjacente aux parties oxydées de la couche épitaxiale, augmentant ainsi la tension de claquage collecteur-émetteur à base ouverte, $LV_{CEO}$ d'un ou plusieurs des transistors verticaux;

à modifier des transistors déterminés parmi la pluralité de transistors verticaux, en détruisant la jonction base-émetteur de chacun desdits transistors déterminés pour former un circuit électrique entre l'émetteur et la base de sorte que chaque transistor modifiée représente un premier état l'information et chaque transistor non modifiée représente un second état d'information différent, la structure comprenant ainsi une mémoire morte programmable.

10. Procédé selon la revendication 9, caractérisé en ce qu'il comprend les opérations de:

formation de ladite région de base dans chacun desdits transistors verticaux de sorte que seul le bord avant de chaque région de base fasse saillie au-delà de chaque région d'émetteur, du transistor vertical, fournissant ainsi un région de base peu profonde avec un gradient élevé de concentration en dopant avec des temps de transit associés très courts dans ledit transistor vertical.

11. Procédé selon la revendication 9 caractérisé en ce qu'il comprend les étapes consistant:

à réaliser lesdits seconds moyens de contact électrique comme une région de contact noyée et d'un second type de conductivité et de concentration en dopant plus élevée que ladite couche épitaxiale, la région de contact noyée étant formée dans ledit substrat directement au-dessous de ladite couche épitaxiale et s'étendant partiellement dans ladite couche épitaxiale, la région de contact noyée s'étendant latéralement au-dessous d'au moins une desdites parties oxydées de ladite couche épitaxiale pour réaliser un contact électrique entre au moins deux desdites îles en matériau semi-conducteur formées dans ladite couche épitaxiale, chacune desdites îles en matériau semi-conducteur comprenant une région de contact s'étendant jusqu'à la surface supérieure de ladite couche épitaxiale, permettant ainsi de réaliser un contact avec ladite région de collecteur.

12. Procédé selon la revendication 9 caractérisé en ce qu'il comprend les étapes consistant:

à réaliser une partie supérieure de chacune desdites îles en matériau semi-conducteur dans ladite couche épitaxiale avec un second type de conductivité mais ayant une concentration en impuretés plus élevée que de ladite couche épitaxiale.

13. Procédé selon la revendication 9 caractérisé en ce qu'il comprend les étapes consistant:

à réaliser un nombre déterminé de lignes de bit d-information disposées parallèlement les unes aux autres, chaque ligne de bit recouvrant et faisant un contact électrique avec ladite région d'émetteur de chacun d'un nombre déterminée desdits transistors verticaux;

à réaliser une pluralité de lignes de mot d'information qui sont sensiblement perpendiculaires aux lignes de bit d'information chaque ligne de mot étant isolée de chaque ligne de bit et chaque lignes de mot recouvrant et réalisant un contact électrique avec un nombre déterminé desdits seconds moyens de contact électrique pour mettre en contact des régions de collecteur déterminé.

# FIG. 1

# FIG. 2a

# FIG. 2b

## FIG. 2c

14a　14d　25c　25d　25e　25a　25f　14e　14b　14f　25g　25b　14g　14c

P　P　N+　N+

N-

N+

23a　22　P　11　13c

## FIG. 2d

14a　25c　25d　25a　25e　25f　14b　25g

P　P　N+　N+

N-

N+

N+
N-

25h　25b

23a　22a　22　11　23c

## FIG. 3

EMITTER-BASE JUNCTION
BASE-COLLECTOR JUNCTION

$2 \times 10^{+20}$
$2 \times 10^{+19}$
$2 \times 10^{+18}$
$2 \times 10^{+16}$

.05　1.0

FIG. 4a

FIG. 4b

FIG. 4e

FIG. 4c

FIG. 4d

NiCr TO VERTICAL FUSE COMPARISON

NiCr                                    Z.E.

SCHEMATIC

FIG.4h    ⇒                ⇒    FIG.4i

LAYOUT

FIG.4f                                  FIG.4g

DIODE

42  EI

BI  61

62

WL

BI

EI  42

TRANSISTOR

CURRENT RAMP WITH VOLTAGE SENSE

FIG.5a

$I_P$

110MA

50MA

$T_{PH}$

$T_{PH} = 1-5\mu s$

$T_{PW} = 250\mu s$

T

FIG.5b

V

VOLTAGE DROP WHEN
CELL IS PROGRAMMED

T

4

FIG. 5c

FIG.5d

N:NUMBER OF PULSES
NEEDED TO PROGRAM
THE CELL

DIRECTION OF BLOW AFTER
N$^{TH}$ PULSE, STOP PULSING

FIG. 5e
UNPROGRAMMED

FIG.5f
PROGRAMMED

FIG. 5g

(1) WITH IMPROVED WORD DRIVER
(2) WORD DRIVER GOES ACTIVE